**Europäisches Patentamt**

**European Patent Office**

**Office européen des brevets**

(19)

(11) Veröffentlichungsnummer: **0 087 818**
**B1**

(12) **EUROPÄISCHE PATENTSCHRIFT**

(45) Veröffentlichungstag der Patentschrift:
**28.12.88**

(51) Int. Cl.⁴: **G 11 C 11/24**

(21) Anmeldenummer: **83102036.7**

(22) Anmeldetag: **02.03.83**

(54) **Integrierter dynamischer Schreib-Lese-Speicher.**

(30) Priorität: **02.03.82 DE 3207498**

(43) Veröffentlichungstag der Anmeldung:
**07.09.83 Patentblatt 83/36**

(45) Bekanntmachung des Hinweises auf die Patenterteilung:
**28.12.88 Patentblatt 88/52**

(84) Benannte Vertragsstaaten:
**AT DE FR GB**

(56) Entgegenhaltungen:
**US-A- 4 061 999**
**US-A- 4 239 993**

**IEEE JOURNAL OF SOLID-STATE CIRCUITS, Band SC-15, Nr. 2, April 1980, Seiten 184-189, IEEE, New York, US; F.J. SMITH et al.: "A 64 kbit MOS dynamic RAM with novel memory capacitor"**

(73) Patentinhaber: **Siemens Aktiengesellschaft Berlin und München, Wittelsbacherplatz 2, D-8000 München 2 (DE)**

(72) Erfinder: **Michael, Ewald, Dipl.-Phys., Jagdfeldring 87, D-8013 Haar (DE)**

# Beschreibung

Die Erfindung betrifft einen integrierten Schreib-Lese-Speicher nach dem Oberbegriff des Patentanspruches 1.

Ein gattungsgemässer Halbleiterspeicher ist aus «IEEE Journal of Solid-State-Circuits», Band SC-15, No. 2, April 1980, Seiten 184 bis 189 bekannt. Aus der US-A 4 061 999 ist bekannt, verschiedene Takte in einem Schaltungsteil zu erzeugen. Aus dieser Literatur ist weiterhin bekannt, ein Umschalten von Transfertransistoren in einen höherohmigen Zustand gleichzeitig mit einer Aktivierung des Komparators durchzuführen.

Bei der üblichen Organisation solcher dynamisch betriebener Schreib-Lese-Speicher ist jeder Spalte der Speichermatrix je eine spaltenparallel verlaufende und mit den in der betreffenden Matrixspalte vorgesehenen Ein-Transistor-Speicherzellen verbundene Bitleitung zugeordnet, die an den einen Eingang des Komparators angeschlossen ist. Am anderen Eingang des Komparators liegt dann eine Vergleichszelle, die im Verein mit dem Komparator es ermöglicht, den digitalen Betriebszustand einer durch die Adressierung ausgewählten Speicherzelle der betreffenden Matrixspalte zu bestimmen.

Sowohl die einzelnen Speicherzellen als auch die einzelnen Vergleichszellen sind als sog. Ein-Transistor-Speicherzellen ausgebildet. Sie bestehen aus je einem selbstsperrenden MOS-Transfertransistor – insbesondere vom n-Kanaltyp – dessen Source bzw. Drain an der zugehörigen Bitleitung und dessen Gate an der der betreffenden Speicherzelle zugeordneten und entlang der die betreffende Speicherzelle enthaltenden Matrixzeile verlaufenden Wortleitung angeschlossen ist. Der andere stromführende Anschluss (Drain bzw. Source) des Transfertransistors der betreffenden Speicherzelle liegt am einen Pol einer – insbesondere durch einen MOS-Varaktor gegebenen – Speicherkapazität, deren zweiter Pol an ein festes Potential der Schaltung, z.B. dem Bezugspotential (Masse) gelegt ist. Für die Vergleichszellen ist eine den Wortleitungen der einzelnen Matrixzeilen entsprechende Adressierleitung (Dummy-Leitung) vorgesehen, über die die Gates der Transfertransistoren der – eine zusätzliche Matrixzeile bildenden – Vergleichszellen über einen Dekoder angesteuert werden. Im übrigen entspricht der Aufbau sowie die Anschaltung der einzelnen Vergleichszellen (Dummy-Zellen) den Verhältnissen bei den eigentlichen Speicherzellen. Die Transfertransistoren der zu den einzelnen Matrixzeilen und damit Wortleitungen gehörenden Speicherzellen liegen, wie bereits angedeutet, gemeinsam mit ihren Gates an der betreffenden Wortleitung und werden über diese angesteuert.

Erfahrungsgemäss ist für die Zugriffszeit bei dynamischen Speichern der zeitliche Ablauf der sog. internen Bewertung, also die Funktion der einander gleichen Komparatoren in den Matrixspalten, von entscheidender Bedeutung.

Man möchte also ein möglichst rasches Reagieren der Komparatoren auf die zugehörigen Bitleitungssignale und Wortleitungssignale erreichen. Eine bekannte Massnahme hierzu ist die Reduktion der Bitleitungskapazität bzw. eine Vorladung der Bitleitungen, um die Lade- bzw. Entladezeit der in den einzelnen Speicher- und Vergleichszellen vorgesehenen Kondensatoren zu verkürzen.

Die Erfindung hat sich die Aufgabe gestellt, eine weitere, im Sinne einer Verkürzung der Ansprechzeit geeignete Möglichkeit anzugeben.

Diese Aufgabe wird bei einem gattungsgemässen Halbleiterspeicher gelöst durch die kennzeichnenden Merkmale des Patentanspruches 1.

Vorteilhafte Aus- und Weiterbildungen sind in Unteransprüchen gekennzeichnet.

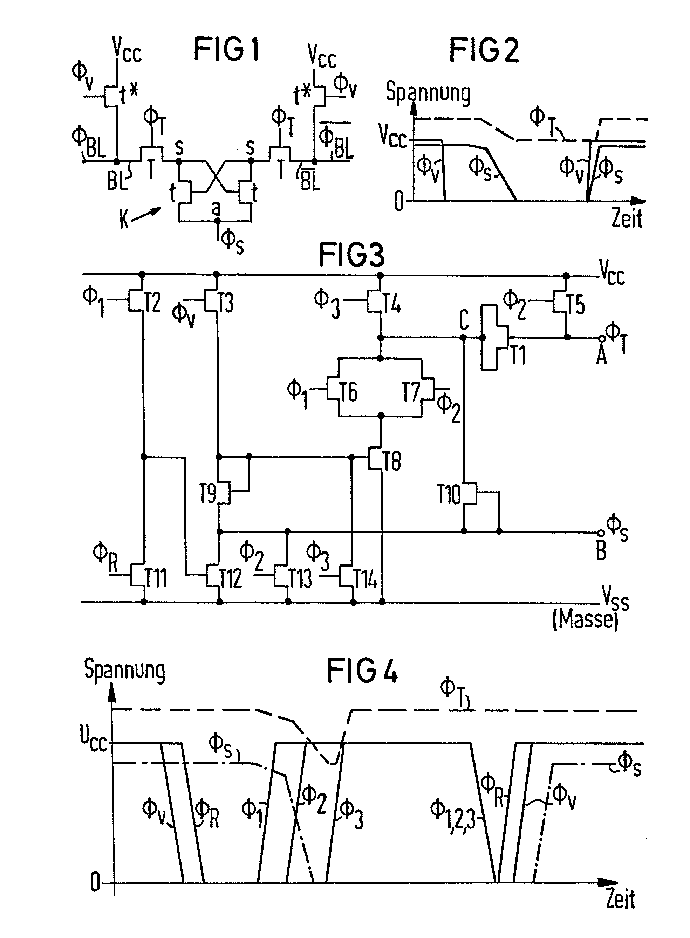

Die Erfindung und deren Wirkungsweise wird nun anhand der Fig. 1 bis 4 näher beschrieben. Dabei sind in Fig. 1 die an sich übliche Anschaltung des Komparators für die einzelnen Matrixspalten des RAM-Speichers und in Fig. 2 das Zeitdiagramm dargestellt, aus dem neben der an sich üblichen Ansteuerung für die Bitleitungsvorladung die erfindungsgemässe Versorgungstaktung des Komparators mittels des Versorgungssignales $\Phi_s$ und die Steuerung der Transfertransistoren durch das Transfersignal $\Phi_T$ und damit der Verbindung zwischen dem Komparator und der zugehörigen Bitleitung ersichtlich ist. Fig. 3 zeigt eine besonders günstige Ausführungsform des Schaltungsteiles für die Erzeugung des Versorgungssignales $\Phi_s$ wie auch des Transfersignales $\Phi_T$. Fig. 4 zeigt das für den Betrieb der Schaltung gemäss Fig. 3 massgebende Zeitdiagramm.

Wie aus Fig. 1 ersichtlich, besteht der Komparator K aus zwei einander gleichen MOS-Feldeffekttransistoren vom selbstsperrenden Typ, die vorzugsweise wie die übrigen Transistoren der Schaltung vom n-Kanaltyp sind. Die beiden Ausgänge s des Komparators K sind dabei durch den Drain je eines der beiden Transistoren t und dem Gate des jeweils anderen Transistors t des Komparators K gegeben, während die beiden Sourceanschlüsse dieser beiden Transistoren t den Versorgungseingang a für den Komparator K bilden. Dieser ist durch ein getaktetes Versorgungssignal $\Phi_s$ beaufschlagt, welches z.B. durch Takten des Bezugspotentials (Masse) gegeben ist. Das andere Versorgungspotential für den Komparator K ist durch den Pegel der über die beiden Transfertransistoren T von der Bitleitung BL bzw. $\overline{BL}$ her an die Signalanschlüsse s des Komparators K gelegten Signale gegeben.

Die beiden Transfertransistoren T bilden die Verbindung zwischen je einem der beiden Signalanschlüsse s des als RS-Flip-Flop oder auch in anderer bekannter Weise ausgestalteten Komparators K mit den jeweils zugeordneten und im einzelnen nicht dargestellten Ein-Transistor-Speicherzellen und Vergleichszellen. Diesbezügliche Einzelheiten findet man z.B. in der DE-AS 3 002 017 oder in «1977 IEEE International Solid-State Circuits Conference», S. 12 und 13. Hinsichtlich der zuletzt genannten Literaturstelle ist zu bemerken, dass auch dort die beiden Signalanschlüsse des Komparators K über je einen MOS-Feldeffekttransistor an die zugehörigen Bitleitungsabschnitte gelegt sind. Jedoch werden diese Transistoren nicht durch ein getaktetes Signal sondern durch ein konstantes Potential beaufschlagt.

Wie bereits aus der zuletzt genannten Literaturstelle ersichtlich, empfiehlt es sich im Interesse eines rascheren Ansprechens des Komparators K die an die Signalanschlüsse s des Komparators zu legenden Bitleitungsabschnitte BL und $\overline{BL}$ vor der Beaufschlagung mit einem Schreibsignal bzw. einem Lesesignal vorzuladen, so dass einerseits eine kürzere Einschreibzeit in die der betreffenden Bitleitung BL, $\overline{BL}$ zugeordneten Speicherzellen bzw. Vergleichszelle, als auch eine höhere Auslesegeschwindigkeit resultiert, und was sich auch in einer Beschleunigung für das Ansprechen des Komparators bemerkbar macht. Hierzu dienen die durch einen gemeinsamen Vorladeimpuls $\Phi_v$ gesteuerten und zwischen dem einzelnen Bitleitungsabschnitt BL bzw. $\overline{BL}$ und dem genannten Versorgungspotential $V_{cc}$ liegenden Ladetransistoren t*. Die Ladetransistoren t* befinden sich während des Schreibbetriebs sowie während des Lesebetriebs auf der dem Komparator K zugeordneten Bitleitung BL und $\overline{BL}$ im gesperrten Zustand und in den Betriebspausen im leitenden Zustand. Gemäss ist auch das aus Fig. 2 und Fig. 4 ersichtliche zeitliche Verhalten der die Transistoren t* steuernden Vorladeimpulse $\Phi_v$ getroffen.

Es ist nun angestrebt, dass die beiden Transfertransistoren T gemeinsam durch Transfersignale $\Phi_T$ gesteuert sind, die inbezug auf die die Vorladung der zu dem betreffenden Komparator K gehörenden Bitleitung BL und $\overline{BL}$ das aus Figur 4 ersichtliche zeitliche Verhalten haben, das auch in der Definition der Erfindung zum Ausdruck gebracht ist. Dabei gelten folgende Gesichtspunkte:

Bekanntlich ist für die Zugriffszeit von dynamischen Speichern der zeitliche Ablauf der internen Signalbewertung durch die Komparatoren K von entscheidender Bedeutung. Auf den Bitleitungsabschnitten BL und $\overline{BL}$ werden das von der jeweils adressierten Speicherzelle bzw. Vergleichszelle gelieferte Signal bzw. Referenzsignal dem Komparator zugeführt. Kritisch für die Aussteuerung der beiden Transfertransistoren T ist deren zeitliche Relation zur Bewertung, die an dem Versorgungsanschluss a durch je einen Impuls des Versorgungssignals $\Phi_s$ eingeleitet wird. Um eine zuverlässigere Bewertung durch den Komparator K zu erreichen, werden die beiden Transfertransistoren T im Vergleich zum normalleitenden Zustand hochohmiger gemacht, ohne dabei den Transfertransistor T zu sperren. (Auf die in der Definition der Erfindung ebenfalls vorgesehene Alternative einer vollständigen Sperrung der Transfertransistoren T wird noch eingegangen.) Im Anschluss an die Bewertung des Betriebszustandes der jeweils ausgewählten Speicherzelle und Vergleichszelle unter den dem betreffenden Komparator K zugehörigen Ein-Transistor-Speicherzellen wird das aufgrund der Bewertung und der damit verbundenen Einstellung des Komparators K an dessen Anschlüssen s zur Verfügung gestellte logische Signal an den zugehörigen Bitleitungsabschnitt BL bzw. $\overline{BL}$ weitergegeben.

Aufgrund der Erfindung ist dabei folgendes Verhalten gegeben, wobei zunächst noch festzustellen ist, dass sich in jedem Fall zwischen den beiden Signalanschlüssen s des Komparators K jeweils eine Signaldifferenz (d. h. die Differenz zweier logischer Pegel «0» und «1») befindet, die auf die beiden zugehörigen Abschnitte BL und $\overline{BL}$ der Bitleitung zu übertragen ist. Vorher jedoch die zwischen den beiden Bitleitungsabschnitten BL und $\overline{BL}$ liegende Signaldifferenz auf den Komparator K zu übertragen, um durch diesen bewertet zu werden. In der ersten Phase für diese Übertragung sind die beiden Transfertransistoren T niederohmig geschaltet und befinden sich deshalb im hochleitenden Zustand. Dadurch kann die Steuerung des Komparators K über die beiden Bitleitungsabschnitte BL und $\overline{BL}$ sehr schnell ablaufen, wodurch der Komparator K in die eine oder in die andere Richtung gekippt wird, je nachdem auf welcher Seite (BL oder $\overline{BL}$) entsprechend der anliegenden logischen Information «0» oder «1» das höhere Potential vorliegt.

Die Rückwirkung des Komparators K auf die beiden Bitleitungsabschnitte BL und $\overline{BL}$ setzt nach der fallenden Flanke des den Versorgungseingang a steuernden Versorgungssignals $\Phi_s$ ein. Um den Kippvorgang des Komparators K, der durch die Aufladung der Kapazität der beiden Transistoren t im Komparator ausgelöst wird, zu beschleunigen, wird gemäss der Erfindung dafür gesorgt, dass das Abfliessen dieser Ladung über den einen oder anderen der beiden Transistoren t im Komparator K dadurch beschleunigt wird, dass die grossen Kapazitäten an BL und $\overline{BL}$ durch hochohmig geschaltete (oder gar gesperrte) Transfertransistoren T abgekoppelt sind. Es ist nämlich zu beachten, dass infolge der Kreuzkoppelung im Komparator K ein Ladungsausgleich zwischen den Bitleitungsabschnitten BL und $\overline{BL}$ im Prinzip eingeleitet wird, was an sich eine Verzögerung des Kippvorgangs bedingt. Um dem abzuhelfen, werden die beiden Bitleitungsabschnitte BL und $\overline{BL}$ unmittelbar nach Zufuhr der für die Auslösung des Kippvorgangs notwendigen Ladungsmenge bereits vor dem Einsetzen des Kippvorgangs weitgehend durch entsprechende Steuerung der Gates der Transfertransistoren entweder völlig gesperrt oder zumindest ausreichend hochohmig gemacht.

Gleichzeitig mit dem Abschluss des während eines eventuellen Kippens des Komparators K aus dem einen in den anderen Betriebszustand am Versorgungseingang a des Komparators K liegenden Versorgungssignales $\Phi_s$ wird gemäss der Erfindung die Verbindung zwischen dem Komparator K und den beiden zugehörigen Bitleitungsabschnitten BL und $\overline{BL}$ wieder geöffnet bzw. niederohmig gemacht, so dass der dann vorliegende logische Zustand an den beiden Signalanschlüssen s des Komparators K unverzüglich auf die beiden Bitleitungsabschnitte BL und $\overline{BL}$ sich auswirken kann.

Die in Fig. 3 dargestellte Schaltung gemäss der Erfindung für einen Schreib-Lese-Speicher erfüllt gleichzeitig zwei Aufgaben, nämlich a) die Erzeugung des für die Taktung der Transfertransistoren T benötigten Transfersignales $\Phi_T$ und b) die Erzeugung des für die Taktung der Versorgungsspannung für den Komparator K erforderlichen Versorgungssignales $\Phi_s$. Da man zweckmässigerweise sämtliche Komparatoren K des Speichers simultan steuert, werden die von einem Schaltungsteil gemäss Fig. 3 erzeugten Signale $\Phi_s$ und $\Phi_T$ gleichzeitig allen diesen Komparatoren K zugeführt.

Der zur Erzeugung des Transfersignales $\Phi_T$ vorgeschlagene Schaltungsteil besteht aus den MOS-FET's T1, T4, T5, T6, T7, T8 und T10, wobei der Transistor T1 auch durch einen Kondensator ersetzt werden kann. In diesem Falle bildet dann der eine Pol des Kondensators den Ersatz für das Gate und der andere Pol den Ersatz für den Source- und Drainanschluss des Transistors T1.

Das gleichzeitig zur Steuerung der Versorgungsspannung für die Komparatoren K dienende Versorgungssignal $\Phi_s$ liegt an Source und Gate des Transistors T10, dessen Drain unmittelbar mit der Source und dem Drain des als Varaktorkapazität vorgesehenen Transistors T1 verbunden ist. Das Gate dieses Transistors T1 liegt an der das angestrebte Transfersignal $\Phi_T$ für die beiden Transfertransistoren T liefernden und auf das Bezugspotential $V_{ss}$ bezogenen Ausgangsklemme A. Ausserdem ist das Gate des Transistors T1 mit dem Sourceanschluss eines durch ein Taktsignal $\Phi_2$ gesteuerten weiteren selbstsperrenden MOS-Transistors T5 verbunden, wobei der Drain dieses Transistors T5 unmittelbar mit dem Versorgungspotential $V_{cc}$ beaufschlagt ist.

Das für die Versorgung der Komparatoren K zuständige Versorgungssignal $\Phi_s$ ist ausserdem, insbesondere unter Vermittlung eines Widerstands (der im Beispielsfall durch den Transistor T9 gegeben ist), an das Gate des Transistors T8 gelegt. Dieser Transistor T8 liegt ausserdem mit seiner Source am Bezugspotential $V_{ss}$ und mit seinem Drain am gemeinsamen Sourceanschluss zweier parallel zueinander geschalteter Transistoren T6 und T7, deren gemeinsamer Drainanschluss einerseits über den Transistor T4 zum Versorgungspotential $V_{cc}$ und andererseits zum Drain des Transistors T10 sowie zum Drain und zur Source des bereits genannten Transistors T1 führt, wie dies aus Fig. 3 ersichtlich ist. Der Transistor T6 wird durch ein erstes Taktsignal $\Phi_1$ gesteuert. Der Transistor T7 wird durch ein zweites Taktsignal $\Phi_2$ gesteuert. Dieses steuert, wie bereits erwähnt, auch den Transistor T5. Ein drittes Taktsignal $\Phi_3$ steuert den Transistor T4. Über den zeitlichen Verlauf dieser Taktsignale wird noch anhand der Fig. 4 näher eingegangen. Ebenso wird die Wirkungsweise dieses der Erzeugung des Transfersignals $\Phi_T$ dienenden Schaltungsteils noch behandelt.

In schaltungstechnischer Beziehung ist noch zu bemerken, dass die beiden Transistoren T6 und T7 auch durch einen einzigen Transistor mit zwei getrennten und gleichwertigen Gates realisiert werden können. Die Möglichkeit, den Transistor T1 durch einen Kondensator zu ersetzen, dessen einer Pol am Signalausgang A und dessen anderer Pol an T10 sowie an T4, T6 und T7 liegt, ist bereits angegeben worden.

Weiter kann die Schaltung noch durch einen Transistor T14 ergänzt werden, der eine Verbindung zwischen dem Gate des Transistors T8 zum Bezugspotential $V_{ss}$ bildet, und der durch dasselbe Taktsignal wie der Transistor T4, also durch das dritte Taktsignal $\Phi_3$ gesteuert ist.

Der zur Erzeugung des die Spannungsversorgung steuernden Versorgungssignales $\Phi_s$ dienende Teil der in Fig. 3 dargestellten Schaltung besteht aus den MOS-Feldeffekttransistoren T2, T3, T9, T11, T12 und T13. Zu seiner Steuerung werden die bereits angegebenen Taktsignale $\Phi_1$, $\Phi_2$ sowie der Vorladeimpuls $\Phi_v$ (vgl. Fig. 1) und ein Resetsignal $\Phi_R$ verwendet.

Dabei ist der Transistor T2 mit seinem Drain an das Versorgungspotential $V_{cc}$, mit seinem Gate an das erste Taktsignal $\Phi_1$ gelegt und mit seiner Source einerseits über die Source-Drainstrecke des vom Resetsignal $\Phi_R$ gesteuerten Transistors T11 mit dem Bezugspotential $V_{ss}$ und andererseits mit dem Gate des Transistors T12 verbunden. Die Source des Transistors T12 liegt ebenso wie die Source des zu ihm parallel geschalteten Transistors T13 am Bezugspotential, während ihre Drains an dem das (auf das Bezugspotential $V_{ss}$ bezogene) Versorgungssignal $\Phi_s$ für die Spannungsbeaufschlagung der Komparatoren K und für die Steuerung der Erzeugung des Transfersignals $\Phi_T$ führenden Ausgang B liegen. Ausserdem sind die Drains dieser beiden Transistoren T12 und T13 über die Source-Drainstrecke des Transistors T9 einerseits mit dem Gate des Transistors T9 und dem Gate des Transistors T8 des der Erzeugung des Transfersignals $\Phi_T$ dienenden Schaltungsteils und andererseits mit der Source eines durch den Vorladeimpuls $\Phi_v$ gesteuerten Transistors T3 und über diesen Transistor T3 mit dem Versorgungspotential $V_{cc}$ verbunden. Zu erwähnen ist noch, dass der bereits genannte und parallel zum Transistor T12 liegende Transistor T13 vom zweiten Taktsignal $\Phi_2$ gesteuert ist, das auch zur Steuerung des am Ausgang A liegenden und bereits erwähnten Transistors T5 dient.

Die in der Schaltung verwendeten Transistoren sind sämtlich selbstsperrende MOS-Feldeffekttransistoren vom selben Kanaltyp, insbesondere vom n-Kanaltyp. Sie lässt sich also ohne weiteres mit den üblichen RAM-Strukturen mit Ein-Transistor-Speicherzellen monolithisch zusammenfassen. Sie kann, wie bereits erwähnt, zur gemeinsamen Steuerung aller Bitleitungen und des jeweils zugeordneten Komparators K dienen. Sie wird daher im Speicher nur in einer einzigen Ausführung benötigt.

In sachlicher Beziehung kann hinsichtlich der Funktion der einzelnen Schaltungsteile gemäss Fig. 3 folgendes festgestellt werden:

a) Der als Varaktor geschaltete Transistor T1 bzw. ein ihn ersetzender Kondensator bewirken die aus Fig. 4 ersichtliche Überhöhung des zur Steuerung der beiden Transfertransistoren T benötigten Transfersignals $\Phi_T$. Durch die Überhöhung wird erreicht, dass die Transistoren T hochleitend sind, während sie in Abwesenheit der Überhöhung den höherohmigen Zustand haben.

b) Die Transistoren T1, T12 und T13 bestimmen die abfallende Flanke für das zur Steuerung der Versorgungseingänge a der Komparatoren K dienende Versorgungssignal $\Phi_s$. Die Vorladeimpulse $\Phi_v$ werden in üblicher Weise erzeugt.

c) Der Transistor T11 erfüllt eine Resetfunktion.

d) Der Transistor T4 wirkt im gleichen Sinne wie der Transistor T1.

e) Die Transistoren T9 und T14 sperren den Transistor T8 beim Auftritt einer durch das Signal $\Phi_3$ bedingten Überhöhung des am Ausgang A erscheinenden Transfersignals $\Phi_T$.

f) Die Transistoren T6, T7 und T8 bestimmen den Verlauf der abfallenden Flanke des am Ausgang A erscheinenden Transfersignals $\Phi_T$.

g) Der Transistor T3 dient der Vorladung des Transistors T8.

h) Der Transistor T10 dient der Steuerung der Überhöhung des Transfersignals $\Phi_T$ durch die ansteigende Flanke des Versorgungssignals $\Phi_s$.

i) Der Transistor T5 bewirkt eine Vorladung des der Erzeugung von $\Phi_T$ dienenden Transistors T1 und damit für $\Phi_T$ eine positive Grundspannung, die durch Einkoppelung über den Transistor T1 überhöht werden kann.

k) Der durch das Taktsignal $\Phi_3$ gesteuerte Transistor T4 ($\Phi_3$ ist dabei auf die Einsatzspannung bezogen) bewirkt das Minimum von $\Phi_T$ und damit den hochohmigen Zustand der beiden Transfertransistoren T in Fig. 1.

Die Taktsignale $\Phi_1$, $\Phi_2$ und $\Phi_3$ haben zeitlich miteinander koinzidierende fallende Flanken und zeitlich gegeneinander etwas verschobene ansteigende Flanken, derart, dass zuerst der Impuls $\Phi_1$, dann mit geringer Verzögerung der Impuls $\Phi_2$ und schliesslich mit geringer Verzögerung der Impuls $\Phi_3$ erscheint. Der Resetimpuls $\Phi_R$ setzt unmittelbar mit dem Verschwinden des Impulses $\Phi_1$, des Impulses $\Phi_2$ und des Impulses $\Phi_3$ ein und endet mit zeitlichem Abstand vor dem Einsetzen des nächstfolgenden Impulses $\Phi_1$. Der Vorladeimpuls $\Phi_v$ fällt zeitlich mit dem Resetimpuls $\Phi_R$ zusammen; jedoch endet er etwas früher und beginnt etwas später als der zugehörige Resetimpuls $\Phi_R$.

Das zeitliche Verhalten der genannten Signale ist, ebenso wie das zeitliche Verhalten der mittels der Anlage gemäss Fig. 3 erzeugten Signale $\Phi_s$ und $\Phi_T$, in Figur 4 dargestellt.

Die Impulse $\Phi_v$ und $\Phi_R$ lassen sich z.B. durch Verstärkung aus Versorgungsimpulsen für den Speicher ableiten. Durch Invertierung mit entsprechenden Verzögerungsgliedern lassen sich die Startflanken von $\Phi_1$, $\Phi_2$ und $\Phi_3$ beispielsweise aus dem Resetimpuls $\Phi_R$ ableiten. Die gemeinsame Stopflanke lässt sich analog zu den Stopflanken von $\Phi_R$ und $\Phi_v$ aus den Versorgungsimpulsen ableiten.

Zu der Wirkung der in Figur 3 dargestellten Schaltung ist nun folgendes im einzelnen festzustellen.

1. Erzeugung des Versorgungssignales $\Phi_s$: Aus Figur 1 ist ersichtlich, dass die Vorladung der Bitleitungsabschnitte BL, $\overline{BL}$ über die vom Vorladeimpuls $\Phi_v$ angesteuerten Transistoren t* erfolgt. Diese wiederum erzeugen gleichzeitig über die Transfertransistoren T (angesteuert vom Transfersignal $\Phi_T$) und die Komparatortransistoren t die Vorladung (positives Spannungsniveau) des Versorgungssignales $\Phi_s$. Die Vorladung von $\Phi_s$ über die Transistoren T3 (von $\Phi_v$ angesteuert) und T9 hat nur eine unterstützende Funktion.

Vor dieser Vorladung (eingeleitet durch die positive Flanke von $\Phi_v$) wird durch die positive Flanke von $\Phi_R$ der Transistor T11 leitend und entladet das Gate des Transistors T12, so dass dieser sperrt, so dass eine Vorladespannung von $\Phi_s$ also nicht abfliessen kann. Der Transistor T2 ist bei diesem Vorgang gesperrt (negative Flanke von $\Phi_1$), um einen Querstrom durch T2 und T11 zu vermeiden.

Um eine zuverlässigere Bewertung durch die Komparatoren K zu erreichen, wird die negative Flanke von $\Phi_s$ in zwei Schritten erzeugt: Die positive Flanke von $\Phi_1$ erzeugt durch das Leiten des Transistors T2 und damit durch das Leiten des Transistors T12 den ersten – flachen – Teil der negativen Flanke von $\Phi_s$. Der zweite – steile – Anteil wird dadurch erzeugt, dass die positive Flanke von $\Phi_2$ den Transistor T13 aufsteuert.

2. Erzeugung des Transfersignales $\Phi_T$: In der Vorladephase von $\Phi_s$ (positive Gatespannung an T3) ist durch den Transistor T3 auch das Gate von T8 aufgeladen und damit der Transistor T8 also geöffnet. Die Transistoren T6 und T7 sind noch gesperrt, und der Knoten C zwischen T4, T6 und T7 erhält eine Vorladung über den Transistor T10. Bei der positiven Flanke von $\Phi_1$ öffnet der Transistor T6, so dass die Ladung auf dem genannten Knoten C über T6 und T8 abzufliessen beginnt. Durch die positive Flanke von $\Phi_1$ (über T2 und T12) beginnt aber auch die negative Flanke von $\Phi_s$, die über T9 ein langsames Absinken der Gatespannung von T8 bewirkt. Mit der positiven Flanke von $\Phi_2$ setzt ein analoger Vorgang wie bei $\Phi_1$ ein. Die Parallelschaltung von T6 und T7 ermöglicht also bei unterschiedlicher Dimensionierung das Abfliessen der Ladung von dem Knoten C in eine langsame und eine schnelle Phase aufzuteilen. Letztlich bewirkt dies durch die kapazitive Kopplung über den Varaktor T1 einen flachen und einen steilen Anteil der negativen Flanke von $\Phi_T$.

Während der positiven Flanke von $\Phi_2$ sinkt aber auch das Versorgungssignal $\Phi_s$ stark ab und reduziert weiter über T9 die Gatespannung an T8. Erreicht $\Phi_s$ das Bezugspotential $V_{ss}$ (Masse), so bleibt T8 wegen der Einsatzspannung von T9 (die grösser als die Einsatzspannung von T8 gehalten werden sollte) noch geöffnet. Die Ladung auf dem Knoten C kann also weiter über T6, T7 und T8 abfliessen.

Mit der positiven Flanke von $\Phi_2$ wird gleichzeitig das Gate von T1 aufgeladen ($\Phi_T$-Vorladung) und

damit der Varaktor T1 bzw. ein an dessen Stelle verwendeter Kondensator geladen. Mit der positiven Flanke von $\Phi_3$ wird dann einerseits über T14 der Transistor T8 vollständig gesperrt (Abschalten des Gates) und andererseits über T4 der Knoten C wieder geladen. Durch kapazitive Kopplung über T1 ergibt sich dabei eine Überhöhung des vorgeladenen Impulses $\Phi_T$. Im nächsten Arbeitszyklus ergibt sich durch Entladung des Knotens C über T6 und T7 die gleiche kapazitive Kopplung über T1, aber in umgekehrter Richtung. Dies bedeutet, dass die $\Phi_T$-Spannung abgesenkt und bei anschliessender positiver $\Phi_3$-Flanke wieder überhöht wird, usw. Die Minimalspannung von $\Phi_T$ lässt sich durch die Vorladespannung von T5 begrenzen.

Die maximalen Spannungsänderungen von $\Phi_T$ ergeben sich durch die Spannungsänderungen am Knoten C zusammen mit dem Verhältnis der Kapazität des Varaktors T1 bzw. eines diesen ersetzenden Kondensators zur Lastkapazität von $\Phi_T$ (in Fig. 3 nicht eingezeichnet). Soll $\Phi_T$ nicht nur teilweise abgesenkt werden, sondern das Bezugspotential $V_{ss}$ (Masse) erreichen, so wird man zweckmässig die in Figur 3 dargestellte Schaltung, wie folgt, etwas abändern:

Die Transistoren T1 und T5 entfallen. Die Impulse $\Phi_T$ werden direkt am Knoten C abgegriffen und der Transistor T10 durch eine Kapazität ersetzt. Die Überhöhung von $\Phi_T$ würde dann erst durch die positive $\Phi_s$-Flanke erzeugt.

Zur Schaltung in Figur 3 ist noch zu bemerken, dass die Transistoren T5 und T10 hauptsächlich zur Förderung des Anlaufens (Einschwingens) der Schaltung gemäss Figur 3 dienen.

**Patentansprüche**

1. Integrierter Schreib-Lese-Speicher mit als Ein-Transistor-Speicherzellen ausgebildeten Speicherzellen, die matrixförmig auf einem Halbleiterchip angeordnet sind, bei dem jeder Matrixspalte ein Komparator (K) und wenigstens eine im Aufbau den Speicherzellen entsprechende und eine zusätzliche Matrixzeile zusammen mit den entsprechenden Vergleichszellen der übrigen Matrixspalten bildende Vergleichszelle zugeordnet ist, bei dem die Adressierung nach den Spalten über je einen Speicherzellen der jeweiligen Spalte jeweils zusammenfassenden ersten Bitleitungsabschnitt (BL) einer Bitleitung sowie bezüglich einer zugehörigen Vergleichszelle über einen zweiten Bitleitungsabschnitt ($\overline{BL}$) derselben Bitleitung und die Adressierung nach den Zeilen durch je eine die zu der betreffenden Matrixzeile gehörenden Ein-Transistor-Speicherzellen zusammenfassende Wortleitung erfolgt, bei dem die beiden Bitleitungsabschnitte (BL, $\overline{BL}$) mit den beiden Signalanschlüssen (s) des Komparators (K) über je einen mittels eines Transfersignals ($\Phi_T$) getakteten Transfertransistor (T) verbunden sind, und bei dem die Spannungsbeaufschlagung des Komparators einerseits aufgrund der der zugehörigen Bitleitung zugeführten Signale und andererseits aufgrund eines Versorgungssignals ($\Phi_s$) erfolgt,

das eine getaktete Verbindung zwischen einem Versorgungspotential und dem durch das Versorgungspotential zu beaufschlagenden Anschluss (a) des Komparators herstellt, gekennzeichnet durch folgende Merkmale:

- Es ist ein gemeinsamer Schaltungsteil (Fig. 3) vorgesehen zur Erzeugung des Transfersignales ($\Phi_T$) und des Versorgungssignales ($\Phi_s$),
- der Schaltungsteil ist so ausgelegt, dass sich aufgrund des Transfersignales ($\Phi_T$) die beiden Transfertransistoren (T) vor dem Anschalten des Komparators (K) an das besagte Versorgungspotential im hochleitenden Zustand befinden, und dann gleichzeitig mit der Aktivierung des Komparators (K) in einen im Vergleich zum hochleitenden Zustand höherohmigen Zustand umgeschaltet bzw. gesperrt werden, während dann unmittelbar mit dem Abschluss der negativen Flanke des Versorgungssignales ($\Phi_s$), der das besagte Versorgungspotential an den Versorgungsanschluss (a) des Komparators (K) legt, der hochleitende Zustand der beiden Transfertransistoren (T) wieder hergestellt ist,
- der das Transfersignal ($\Phi_T$) erzeugende Teil des Schaltungsteils enthält folgende erste Schaltungsanordnung:
  - ein erster und ein zweiter Transfersignal-Transistor (T6, T7) sind zueinander parallel geschaltet und mit ihrem Sourceanschluss über die Drain-Sourcestrecke eines dritten Transfersignal-Transistors (T8) mit dem Bezugspotential ($V_{ss}$) und über die Source-Drainstrecke eines vierten Transfersignal-Transistors (T4) mit dem Versorgungspotential ($V_{cc}$) verbunden,
  - das Gate des ersten Transfersignal-Transistors (T6) ist durch ein erstes Taktsignal ($\Phi_1$), das Gate des zweiten Transfersignal-Transistors (T7) durch ein zweites Taktsignal ($\Phi_2$), das Gate des dritten Transfersignal-Transistors (T8) durch das Versorgungssignal ($\Phi_s$) und das Gate des vierten Transfersignal-Transistors (T4) durch ein drittes Taktsignal ($\Phi_3$) gesteuert,
  - die am Schaltungsknoten (C) zwischen dem ersten und zweiten Transfersignal-Transistor (T6, T7) und dem vierten Transfersignal-Transistor (T4) liegenden Potentiale dienen einerseits zur Steuerung des das Transfersignal ($\Phi_T$) für die Transfertransistoren (T) liefernden Ausgangs (A), und sind andererseits selbst durch das Versorgungssignal ($\Phi_s$) zusätzlich zu der Steuerung über den dritten Transfersignal-Transistor (T8) beeinflusst,
- der das Versorgungssignal ($\Phi_s$) erzeugende Teil des Schaltungsteils enthält folgende zweite Schaltungsanordnung:
  - Zur Erzeugung des Versorgungssignales ($\Phi_s$) dient ein durch ein Resetsignal ($\Phi_R$) gesteuerter erster Versorgungssignal-Transistor (T11), der mit seinem Sourceanschluss an Bezugspotential ($V_{ss}$) liegt und der mit seinem Drain sowohl zur Steuerung eines zweiten – ebenfalls mit seinem Source an Bezugspotential ($V_{ss}$) liegenden – Versorgungssignal-

Transistors (T12) dient und der ausserdem mit seinem Drain über einen dritten durch das erste Taktsignal ($\Phi_1$) gesteuerten Versorgungssignal-Transistor (T2) an das Versorgungspotential ($V_{cc}$) angelegt ist,

- der Drain des zweiten Versorgungssignal-Transistors (T12) ist als Signalausgang (B) für das zu erzeugende Versorgungssignal ($\Phi_s$) vorgesehen,
- dem zweiten Versorgungssignal-Transistor (T12) ist ein vierter Versorgungssignal-Transistor (T13) parallelgeschaltet, dessen Gate durch das zweite Taktsignal ($\Phi_2$) beaufschlagt ist,
- die Parallelschaltung des zweiten und des vierten Versorgungssignal-Transistors (T12, T13) ist über einen fünften Versorgungssignal-Transistor (T3), der durch einen für die Vorladung der Bitleitungen (BL, $\overline{BL}$) der Speichermatrix vorgesehenen Vorladeimpuls ($\Phi_v$) gesteuert ist, mit dem Versorgungssignal ($V_{cc}$) verbunden.

2. Anordnung nach Anspruch 1, dadurch gekennzeichnet, dass sie aus selbstsperrenden Feldeffekttransistoren, insbesondere vom n-Kanaltyp, aufgebaut ist.

3. Anordnung nach Anspruch 1 oder 2, dadurch gekennzeichnet, dass der zwischen dem ersten, dem zweiten und dem vierten Transfersignal-Transistor (T6, T7, T4) liegende Schaltungsknoten (C) einerseits über einen Kondensator (T1) an die das zur Steuerung der beiden Transfertransistoren (T) benötigte Transfersignal ($\Phi_T$) liefernde Ausgangsklemme (A) und andererseits über die Source-Drain-Strecke eines fünften Transfersignal-Transistors (T10) durch das – gleichzeitig auch das Gate des fünften Transfersignal-Transistors (T10) einwirkende – Versorgungssignal ($\Phi_s$) für die Taktung der Versorgung für den Komparator (K) beaufschlagt ist, und dass schliesslich der das zur Steuerung der Transfertransistoren (T) an den Signalanschlüssen (s) der Komparatoren (K) dienende Ausgang (A) über die Source-Drain-Strecke eines durch das zweite Taktsignal ($\Phi_2$) gesteuerten sechsten Transfersignal-Transistors (T5) an das Versorgungspotential ($V_{cc}$) angeschaltet ist.

4. Anordnung nach Anspruch 1, 2 oder 3, dadurch gekennzeichnet, dass die Steuerung des Gates des dritten Transfersignal-Transistors (T8) durch das Versorgungssignal ($\Phi_s$) unter Vermittlung eines Widerstandes, z.B. eines als Widerstand geschalteten Transistors (T9) gegeben ist.

5. Anordnung nach einem der vorhergehenden Ansprüche, dadurch gekennzeichnet, dass der am Ausgang (A) für das die Steuerung der Transfertransistoren (T) bewirkende Transfersignal ($\Phi_T$) liegende Kondensator durch einen als Varaktor geschalteten Feldeffekttransistor (T1) vom Typ der übrigen Transistoren im Speicher gegeben ist.

6. Anordnung nach Anspruch 5, dadurch gekennzeichnet, dass Source und Drain des als Varaktor geschalteten Transistors (T1) mit dem Schaltungsknoten (C) zwischen dem vierten Transfersignal-Transistor (T4) und den beiden ersten Transfersignal-Transistoren (T6, T7) verbunden sind, während sein Gate unmittelbar an der das Transfersignal ($\Phi_T$) liefernden Ausgangsklemme (A) liegt.

7. Anordnung nach einem der vorhergehenden Ansprüche, dadurch gekennzeichnet, dass das Gate des dritten Transfersignal-Transistors (T8) über die Source-Drain-Strecke eines durch das dritte Taktsignal ($\Phi_3$) gesteuerten weiteren Transistors (T14) mit dem Bezugspotential ($V_{ss}$) verbunden ist.

8. Anordnung nach einem der vorhergehenden Ansprüche, dadurch gekennzeichnet, dass zwischen dem fünften Versorgungssignal-Transistor (T3) einerseits und dem zweiten und dem vierten Versorgungssignal-Transistor (T12, T13) andererseits ein weiterer Transistor (T9) vorgesehen ist, dessen Gate ebenfalls mit der Source des fünften Versorgungssignal-Transistors (T3) verbunden ist.

9. Anordnung nach Anspruch 8, dadurch gekennzeichnet, dass die Source des fünften Versorgungssignal-Transistors (T3) sowie der Drain des zweiten und des vierten Versorgungssignal-Transistors (T12, T13) jeweils zur Steuerung der das Transfersignal ($\Phi_T$) erzeugenden ersten Schaltungsanordnung vorgesehen ist.

10. Anordnung nach einem der Ansprüche 3 bis 9, dadurch gekennzeichnet, dass der Drain des zweiten Versorgungssignal-Transistors (T12) der das Versorgungssignal ($\Phi_s$) erzeugenden zweiten Schaltungsanordnung mit dem Drain und dem Gate des fünften Transfersignal-Transistors (T10) in der das Transfersignal ($\Phi_T$) erzeugenden ersten Schaltungsanordnung sowie die Source des fünften Versorgungssignal-Transistors (T3) der zweiten Schaltungsanordnung unmittelbar mit dem Gate des dritten Transfersignal-Transistors (T8) der ersten Schaltungsanordnung verbunden ist.

11. Anordnung nach einem der Ansprüche 3 bis 10, dadurch gekennzeichnet, dass die zur Steuerung des Schaltungsteils vorgesehenen Taktsignale ($\Phi_1$, $\Phi_2$, $\Phi_3$, $\Phi_v$, $\Phi_R$) derart zueinander zeitlich abgestimmt sind, dass das erste, das zweite und das dritte Taktsignal ($\Phi_1$, $\Phi_2$, $\Phi_3$) gleichzeitig enden, während das erste Taktsignal ($\Phi_1$) zeitlich etwas früher als das zweite Taktsignal ($\Phi_2$) und letzteres etwas früher als das dritte Taktsignal ($\Phi_3$) einsetzt.

12. Anordnung nach Anspruch 11, dadurch gekennzeichnet, dass der der Vorladung der Bitleitungen (BL, $\overline{BL}$) dienende Vorladeimpuls ($\Phi_v$) zeitlich etwas später als der zugehörige Resetimpuls ($\Phi_R$) beginnt und etwas frühre als dieser endet und dass die Resetimpulse ($\Phi_R$) jeweils in die Pause zwischen jeweils zwei aufeinanderfolgende Impulse des ersten Taktsignales ($\Phi_1$) fallen, ohne dass es dabei zu einer Überschneidung mit den benachbarten Impulsen des ersten Taktsignales ($\Phi_1$) kommt.

13. Anordnung nach einem der vorhergehenden Ansprüche, dadurch gekennzeichnet, dass der Schaltungsknoten (C) zwischen dem ersten, dem zweiten und dem vierten Transfersignal-Transistor (T6, T7, T4) unmittelbar an den das Transfersi-

gnal ($\Phi_T$) liefernden Ausgang (A) gelegt ist und ausserdem über einen Kondensator an einen das Versorgungssignal ($\Phi_s$) führenden Schaltungspunkt (B) gelegt ist.

## Claims

1. Integrated read-write memory having memory cells which are designed as single-transistor memory cells and are arranged in the form of a matrix on a semi-conductor chip, in which a comparator (K) and at least one comparator cell are assigned to each matrix column, said comparator cell corresponding in its construction to the memory cells and forming an additional matrix line together with the corresponding comparator cells of the remaining matrix columns, in which the addressing to the columns is made in each case via a first bit line section (BL) of a bit line, in each case combining memory cells of the respective column, as well as with respect to an associated comparator cell, via a second bit line section ($\overline{BL}$) of the same bit line, and the addressing to the lines is made in each case by one word line, combining the single-transistor memory cells belonging to the corresponding matrix line, in which the two bit line sections (BL, $\overline{BL}$) are each connected to the two signal connections (S) of the comparator (K) via a transfer transistor (T) clock-pulsed by means of a transfer signal ($\Phi_T$), and in which a voltage is applied to the comparator on the one hand on the basis of the signals supplied to the associated bit line and, on the other hand, on the basis of a supply signal ($\Phi_s$) which provides a clock-pulsed connection between a supply potential and the connection (a) to which the supply potential is to be applied, of the comparator, characterized by the following features:

– A common circuit part (Fig. 3) is provided for generating the transfer signal ($\Phi_T$) and the supply signal ($\Phi_s$),

– the circuit part is designed so that, on the basis of the transfer signal ($\Phi_T$), the two transfer transistors (T) are in the highly conductive state before the connection of the comparator (K) to the said supply potential, and are then, at the same time as the comparator (K) is activated, switched to a higher impedance state in comparison to the highly conductive state or blocked, white then directly upon the termination of the negative edge of the supply signal ($\Phi_s$) which applies the said supply potential to the supply connection (a) of the comparator (K), the highly conductive state of the two transfer transistors (T) is again produced,

– the part of the circuit part producing the transfer signal ($\Phi_T$) contains the following first circuit arrangement:

– a first and a second transfer signal transistor (T6, T7) are connected in parallel to each other and are connected with their source connection via the drain-source system of a third transfer signal transistor (T8) to the reference potential ($V_{ss}$) and via the source-drain system of a fourth transfer signal transistor (T4) to the supply potential ($V_{cc}$),

– the gate of the first transfer signal transistor (T6) is controlled by a first clock signal ($\Phi_1$), the gate of the second transfer signal transistor (T7) is controlled by a second clock signal ($\Phi_2$), the gate of the third transfer signal transistor (T8) is controlled by the supply signal ($\Phi_s$) and the gate of the fourth transfer signal transistor (T4) is controlled by a third clock signal ($\Phi_3$),

– the potentials present at the circuit junction (C) between the first and second transfer signal transistor (T6, T7) and the fourth transfer signal transistor (T4) serve on the one hand for controlling the output (A) supplying the transfer signal ($\Phi_T$) for the transfer transistors (T), and they are, on the other hand, themselves influenced by the supply signal ($\Phi_s$) in addition to the control via the third transfer signal transistor (T8),

– the part of the circuit part generating the supply signal ($\Phi_s$) contains the following second circuit arrangement:

– a first supply signal transistor (T11) controlled by a reset signal ($\Phi_R$) serves to generate the supply signal ($\Phi_s$), the source connection of which supply signal transistor lies at reference potential ($V_{ss}$) and the drain of which serves both to control a second supply signal transistor (T12) – likewise with its source connection lying at reference potential ($V_{ss}$) – and which is additionally, with its drain, applied to the supply potential ($V_{cc}$) via a third supply signal transistor (T2) controlled by the first clock signal ($\Phi_1$),

– the drain of the second supply signal transistor (T12) is intended as the signal output (B) for the supply signal ($\Phi_s$) to be generated,

– connected in parallel to the second supply signal transistor (T12) is a fourth supply signal transistor (T13), to the gate of which the second clock signal ($\Phi_2$) is applied,

– the parallel conncetion of the second and the fourth supply signal transistor (T12, T13) is connected via a fifth supply signal transistor (T3), which is controlled by a precharging pulse ($\Phi_v$) provided for the precharging of the bit lines (BL, $\overline{BL}$) of the memory matrix, to the supply signal ($V_{cc}$).

2. Arrangement according to Claim 1, characterized in that the arrangement is constructed of self-locking field effect transistors, in particular of the n-channel type.

3. Arrangement according to Claim 1 or 2, characterized in that the circuit junction (C) lying between the first, the second and the fourth transfer signal transistor (T6, T7, T4) is acted upon on the one hand by a capacitor (T1) at the output terminal (A) supplying the transfer signal ($\Phi_T$) required for controlling the two transfer transistors (T) and, on the other hand, via the source-drain system of a fifth transfer signal transistor (T10) by the supply signal ($\Phi_s$) – simultaneously also acting upon the gate of the fifth transfer signal transistor (T10) – for the clocking of the supply for the comparator (K) and that finally the output (A) serving to control the transfer transistors (T) at the signal connections (s) of the comparators (K) is connected to the supply potential ($V_{cc}$) via the source-drain system of a sixth transfer signal transistor (T5) controlled by the second clock signal ($\Phi_2$).

4. Arrangement according to Claim 1, 2 or 3, characterized in that the control of the gate of the third transfer signal transistor (T8) is effected by the supply signal ($\Phi_s$) with the intermediary of a resistor, for example a transistor (T9) connected as a resistor.

5. Arrangement according to one of the preceding claims, characterized in that the capacitor lying at the output (A) for the transfer signal ($\Phi_T$) effecting the control of the transfer transistors (T) is a field effect transistor (T1) connected as a varactor and of the type of the remaining transistors in the memory.

6. Arrangement according to Claim 5, characterized in that the source and drain of the transistor (T1) connected as a varactor are connected to the circuit junction (C) between the fourth transfer signal transistor (T4) and the two first transfer signal transistors (T6, T7), while the gate of said transistor lies directly at the output terminal (A) supplying the transfer signal ($\Phi_T$).

7. Arrangement according to one of the preceding claims, characterized in that the gate of the third transfer signal transistor (T8) is connected to the reference potential ($V_{ss}$) via the source-drain system of a further transistor (T14) controlled by the third clock signal ($\Phi_3$).

8. Arrangement according to one of the preceding claims, characterized in that, between the fifth supply signal transistor (T3) on the one hand and the second and the fourth supply signal transistor (T12, T13) on the other hand, a further transistor (T9) is provided, the gate of which is likewise connected to the source of the fifth supply signal transistor (T3).

9. Arrangement according to Claim 8, characterized in that the source of the fifth supply signal transistor (T3) as well as the drain of the second and the fourth supply signal transistor (T12, T13) is in each case provided for controlling the first circuit arrangement generating the transfer signal ($\Phi_T$).

10. Arrangement according to one of Claims 3 to 9, characterized in that the drain of the second supply signal transistor (T12) of the second circuit arrangement generating the supply signal ($\Phi_s$) is connected to the drain and to the gate of the fifth transfer signal transistor (T10) in the first circuit arrangement generating the transfer signal ($\Phi_T$), and the source of the fifth supply signal transistor (T3) of the second circuit arrangement is directly connected to the gate of the third transfer signal transistor (T8) of the first circuit arrangement.

11. Arrangement according to one of Claims 3 to 10, characterized in that the clock signals ($\Phi_1$, $\Phi_2$, $\Phi_3$, $\Phi_v$, $\Phi_R$) provided for control of the circuit part are synchronized with each other in such a manner that the first, the second and the third clock signal ($\Phi_1$, $\Phi_2$, $\Phi_3$) end simultaneously, while the first clock signal ($\Phi_1$) begins temporally slightly earlier than the second clock signal ($\Phi_2$) and the latter begins slightly earlier than the third clock signal ($\Phi_3$).

12. Arrangement according to Claim 11, characterized in that the precharging pulse ($\Phi_v$) serving to precharge the bit lines (BL, $\overline{BL}$) begins temporally slightly later than the associated reset pulse ($\Phi_R$) and ends slightly earlier than the latter and in that the reset pulses ($\Phi_R$) each fall in the pause between each successive two pulses of the first clock signal ($\Phi_1$), without in doing so resulting in an overlapping with the adjacent pulses of the first clock signal ($\Phi_1$).

13. Arrangement according to one of the preceding claims, characterized in that the circuit junction (C) is positioned between the first, the second and the fourth transfer signal transistor (T6, T7, T4) directly at the output (A) supplying the transfer signal ($\Phi_T$) and in addition is positioned above a capacitor at a circuit point (B) carrying the supply signal ($\Phi_s$).

**Revendications**

1. Mémoire à lecture-écriture intégrée, comprenat des cellules de mémoire réalisées comme des cellules à un transistor, qui sont disposées en forme de matrice sur une puce à semi-conducteurs, dans laquelle un comparateur (K) et au moins une cellule de comparaison sont coordonnés à chaque colonne de la matrice, la cellule de comparaison correspondant à la constitution des cellules de mémoire et formant une ligne de matrice supplémentaire ensemble avec les cellules de comparaison correspondantes des autres colonnes de la matrice, dans laquelle l'adressage selon les colonnes s'opère chaque fois à travers un premier segment (BL) d'une ligne de bit, rassemblant des cellules de mémoire de la colonne concernée, et à travers un second segment ($\overline{BL}$) de la même ligne de bit pour ce qui concerne une cellule de comparaison associée, et l'adressage selon les lignes s'opère chaque fois par une ligne de mot, rassemblant les cellules de mémoire à un transistor appartenant à la ligne concernée de la matrice, dans laquelle les deux segments de ligne de bit (BL, $\overline{BL}$) sont reliés aux deux connections de signal (s) du comparateur (K), chacun à travers un transistor de transfert (T) cadencé au moyen d'un signal de transfert ($\Phi_r$), et dans laquelle l'application de la tension au comparateur s'effectue d'une part sur la base de signaux amenés à la ligne de bit associée et d'autre part sur la base d'un signal d'alimentation ($\Phi_s$) qui établit une liaison cadencée entre un potentiel d'alimentation et la connexion (a) du comparateur à laquelle est à appliquer le potentiel d'alimentation, caractérisée en ce que:

– elle comporte une partie de circuit commune (Fig. 3) pour la génération du signal de transfert ($\Phi_T$) et du signal d'alimentation ($\Phi_s$),

– cette partie de circuit est conçue de manière que sous l'effet du signal de transfert ($\Phi_T$), les deux transistors de transfert (T) se trouvent à l'état hautement conducteur avant la connexion du comparateur (K) audit potentiel d'alimentation, et qu'ils soient commutés ensuite à un état à impédance accrue, comparativement à l'état hautement conducteur, ou soient bloqués, en même temps que le comparateur (K) est activé, alors que l'état hautement conducteur des deux transistors de transfert (T) est rétabli dès que s'achève le flanc négatif du signal d'alimentation (Φ$_s$), lequel applique ledit potentiel d'alimentation à la borne d'alimentation (a) du comparateur (K),
- la section générant le signal de transfert (Φ$_T$) de ladite partie de circuit contient le premier circuit suivant:
  - un premier et un deuxième transistor à signal de transfert (T6, T7) sont connectés en parallèle et sont reliés par leur connexion de source au potentiel de référence (V$_{ss}$) à travers le parcours drain-source d'un troisième transistor à signal de transfert (T8) et au potentiel d'alimentation (V$_{cc}$) à travers le parcours source-drain d'un quatrième transistor à signal de transfert (T4),
  - la grille du premier transistor à signal de transfert (T6) est commandée par un premier signal d'horloge (Φ$_1$), la grille du deuxième transistor à signal de transfert (T7) par un deuxième signal d'horloge (Φ$_2$), la grille du troisième transistor à signal de transfert (T8) par le signal d'alimentation (Φ$_s$) et la grille du quatrième transistor à signal de transfert (T4) par un troisième signal d'horloge (Φ$_3$),
  - les potentiels appliqués au nœud (C) entre les premier et deuxième transistors à signal de transfert (T6, T7) et le quatrième transistor à signal de transfert (T4), servent d'une part à la commande de la sortie (A) fournissant le signal de transfert (Φ$_T$) pour les transistors de transfert (T) et sont eux-mêmes influencés d'autre part par le signal d'alimentation (Φ$_s$), en plus de la commande par le troisième transistor à signal de transfert (T8),
- la section générant le signal d'alimentation (Φ$_s$) de ladite partie de circuit contient le second circuit suivant:
  - le signal d'alimentation (Φ$_s$) est généré au moyen d'un premier transistor à signal d'alimentation (T11), cmmandé par un signal de remise à zéro (Φ$_R$), qui est relié par sa connexion de source au potentiel de référence (V$_{ss}$) et dont le drain sert à la fois à commander un deuxième transistor à signal d'alimentation (T12) - relié également au potentiel de référence (V$_{ss}$) par sa connexion de source - et à établir la liaison avec le potentiel d'alimentation (V$_{cc}$) à travers un troisième transistor à signal d'alimentation (T2) commandé par le premier signal d'horloge (Φ$_1$),
  - le drain du deuxième transistor à signal d'alimentation (T12) est prévu comme sortie de signal (B) pour le signal d'alimentation (Φ$_s$) à générer,
  - un quatrième transistor à signal d'alimentation (T13) est connecté en parallèle avec le deuxième transistor à signal d'alimentation (T12) et reçoit sur sa grille le deuxième signal d'horloge (Φ$_2$) et
  - le montage en parallèle des deuxième et quatrième transistors à signal d'alimentation (T12, T13) est relié au signal d'alimentation (V$_{cc}$) à travers un cinquième transistor à signal d'alimentation (T3) commandé par une impulsion de précharge (Φ$_v$) prévue pour précharger les lignes de bit (BL, $\overline{BL}$) de la matrice de la mémoire.

2. Mémoire selon la figure 1, caractérisée en ce qu'elle est constituée de transistors à effet de champ autobloquants, en particulier du type à canal n.

3. Mémoire selon la revendication 1 ou 2, caractérisée en ce que le nœud (C) entre les premier, deuxième et quatrième transistors à signal de transfert (T6, T7, T4) est relié d'une part, à travers un condensateur (T1), à la borne de sortie (A) fournissant le signal de transfert (Φ$_T$) nécessaire à la commande des deux transistors de transfert (T) et reçoit d'autre part, à travers le parcours source-drain d'un cinquième transistor à signal de transfert (T10), le signal d'alimentation (Φ$_s$) pour le cadencement de l'alimentation du comparateur (K) - signal qui agit en même temps sur la grille du cinquième transistor à signal de transfert (T10) - et que, enfin, la sortie (A), servant à commander le raccordement des transistors de transfert (T) aux connexions de signal (s) des comparateurs (K), est reliée au potentiel d'alimentation (V$_{cc}$) à travers le parcours source-drain d'un sixième transistor à signal de transfert (T5) commandé par le deuxième signal d'horloge (Φ$_2$).

4. Mémoire selon la revendication 1, 2 ou 3, caractérisée en ce que la commande de la grille du troisième transistor à signal de transfert (T8), par le signal d'alimentation (Φ$_s$), s'effectue avec interposition d'une résistance, par exemple d'un transistor (T9) monté en résistance.

5. Mémoire selon une des revendications précédentes, caractérisée en ce que le condensateur relié à la sortie (A) pour le signal de transfert (Φ$_T$), produisant la commande des transistors de transfert (T), est constitué par un transistor à effet de champ (T1), monté en varactor, qui est du même type que les autres transistors de la mémoire.

6. Mémoire selon la revendication 5, caractérisée en ce que la source et le drain du transistor (T1) monté en varactor, sont reliés au nœud (C) entre le quatrième transistor à signal de transfert (T4) et les deux premiers transistors à signal de transfert (T6, T7), tandis que sa grille est reliée directement à la borne de sortie (A) fournissant le signal de transfert (Φ$_T$).

7. Mémoire selon une des revendications précédentes, caractérisée en ce que la grille du troisième transistor à signal de transfert (T8) est reliée au potentiel de référence (V$_{ss}$) à travers le circuit source-drain d'un autre transistor (T14) commandé par le troisième signal d'horloge (Φ$_3$).

8. Mémoire selon une des revendications précédentes, caractérisée en ce qu'un transistor supplémentaire (T9) dont la grille est également reliée à la source du cinquième transistor à signal d'alimentation (T3), est connecté entre le cinquième transistor à signal d'alimentation (T3) d'une part et les deuxième et quatrième transistors à signal d'alimentation (T12, T13) d'autre part.

9. Mémoire selon la revendication 8, caractérisée en ce que la source du cinquième transistor à signal d'alimentation (T3) et le drain des deuxième et quatrième transistors à signal d'alimentation (T12, T13) sont prévus pour la commande du premier circuit générateur du signal de transfert ($\Phi_T$).

10. Mémoire selon une des revendications 3 à 9, caractérisée en ce que le drain du deuxième transistor à signal d'alimentation (T12), du second circuit, produisant le signal d'alimentation ($\Phi_s$), est relié au drain et à la grille du cinquième transistor à signal de transfert (T10) dans le premier circuit, produisant le signal de transfert ($\Phi_T$), et que la source du cinquième transistor à signal d'alimentation (T3), du second circuit, est relié directement à la grille du troisième transistor à signal de transfert (T8) du premier circuit.

11. Mémoire selon une des revendications 3 à 10, caractérisée en ce que les signaux d'horloge ($\Phi_1$, $\Phi_2$, $\Phi_3$, $\Phi_v$, $\Phi_R$) prévus pour la commande de ladite partie de circuit, sont mutuellement accordés dans le temps, de manière que les premier, deuxième et troisième signaux d'horloge ($\Phi_1$, $\Phi_2$, $\Phi_3$) se terminent simultanément, tandis que le premier signal d'horloge ($\Phi_1$) commence un peu plus tôt que le deuxième signal d'horloge ($\Phi_2$) et que ce dernier commence un peu plus tôt que le troisième signal d'horloge ($\Phi_3$).

12. Mémoire selon la revendication 11, caractérisée en ce que l'impulsion de précharge ($\Phi_v$), servant à précharger les lignes de bit (BL, $\overline{BL}$), commence un peu plus tard que l'impulsion de remise à zéro ($\Phi_R$) associée et se termine un peu plus tôt que cette impulsion et que les impulsions de remise à zéro ($\Phi_R$) tombent chacune dans l'intervalle entre deux impulsions successives du premier signal d'horloge ($\Phi_1$), sans qu'il se produise un chevauchement avec les impulsions voisines du premier signal d'horloge ($\Phi_1$).

13. Mémoire selon une des revendications précédentes, caractérisée en ce que le nœud (C) entre les premier, deuxième et quatrième transistors à signal de transfert (T6, T7, T4) est relié directement à la sortie (A) fournissant le signal de transfert ($\Phi_T$) et est relié, en outre, à travers un condensateur, à un point de circuit (B) présentant le signal d'alimentation ($\Phi_s$).

FIG 1

FIG 2

FIG 3

FIG 4